# EUROPEAN PATENT SPECIFICATION

(11) **EP 2 339 632 B1**
(45) Date of publication and mention of the grant of the patent: **12.03.2014**
(21) Application number: 10015888.0
(22) Date of filing: 21.12.2010
(51) Int. Cl.: H01L 27/146

(54) **Image sensor and method of manufacturing the same, and sensor device**
Bildsensor und Verfahren zu dessen Herstellung und Sensorvorrichtung
Capteur d'images et son procédé de fabrication, et dispositif de capteur

(30) Priority: 28.12.2009 JP 2009298487
(43) Date of publication of application: 29.06.2011
(73) Proprietor: Sony Corporation, Tokyo 108-0075 (JP)
(72) Inventor: Kasai, Hiroto, Tokyo 108-0075 (JP); Minakawa, Tatsuya, Tokyo 108-0075 (JP); Aki, Yuichi, Tokyo 108-0075 (JP); Hashimoto, Makoto, Tokyo 108-0075 (JP); Taguchi, Ayumu, Tokyo 108-0075 (JP); Yamasaki, Takeshi, Tokyo 108-0075 (JP); Ichimura, Isao, Tokyo 108-0075 (JP); Maeda, Keiichi, Tokyo 108-0075 (JP)
(74) Representative: Müller - Hoffmann & Partner

(56) References cited:
- EP-A1- 1 325 776
- WO-A1-98/09336
- WO-A1-99/49974
- WO-A1-2009/001988
- WO-A2-93/22678
- FR-A1- 2 908 888
- US-B1- 7 316 930

## Description

### CROSS REFERENCES TO RELATED APPLICATIONS

The present application claims priority to Japanese Priority Patent Application JP 2009-298487 filed in the Japan Patent Office on December 28, 2009.

### BACKGROUND

The present application relates to a method of manufacturing an image sensor, and a sensor device having the same mounted thereto. More particularly, the present application relates to a method of manufacturing a structure of an image sensor for carrying out a measurement for either a gel-like or liquid specimen, and a sensor device having the same mounted thereto.

In recent years, a demand for either a chemical sensor or a biosensor for displaying a result of a pH measurement about a liquid solution, a result of an analysis about DNA or proteins, or the like in the form of a two-dimensional image has increased. A Light Addressable Potentiometric Sensor (LAPS) utilizing a Surface Potential Measuring Method (SPV Method) of reading a surface potential of a semiconductor element from a photoexcited current caused by a condensed light spot, for example, is known as such a chemical sensor. The LAPS, for example, is described in Japanese Patent Laid-Open Nos. 2002-131276 and 2008-241335 (hereinafter referred to as Patent Documents 1 and 2).

On the other hand, although each of the existing chemical sensors, for example, described in Patent Documents 1 and 2 can take in a detected image in the form of a two-dimensional map, a transparent substrate and a transparent electrode are both required because a light is made incident to a substrate surface. In addition, each of those chemical sensors includes one light source and one element. Therefore, even when the light source is made in a spot state, photoexcited carriers generated diffuse in a planar direction of a semiconductor element, so that a range of the photoexcited current becoming an object of an observation spreads. For this reason, there is caused such a problem that an image resolution is low.

Then, heretofore, the chemical sensor or the biosensor using a solid-state image pickup element such as a Charge Coupled Device (CCD) or a Complementary Metal Oxide Semiconductor (CMOS) image sensor as a detecting section has been proposed as a device which has a high detection sensitivity, from which a signal containing therein a less noise component can be obtained, and which can output a charge signal as two-dimensional data. The chemical sensor or the biosensor, for example, is described in Japanese Patent Laid-Open Nos. 2004-301648, 2009-165219, 2006-162585, and 2005-227155 (hereinafter referred to as Patent Documents 3 to 6). In addition, a liquid solution component sensor has also been known in which a light source, cells and a light receiving portion are formed integrally with one another on a semiconductor substrate. This liquid solution component sensor, for example, is described in Japanese Patent Laid-Open No. Hei 6-18421 (hereinafter referred to as Patent Document 7).

### SUMMARY

However, the related art described above involves the following problems. That is to say, in the case of the analyzing apparatuses described in Patent Documents 3 and 4, when the high resolution is required, a section for carrying out alignment between a well and a detector needs to be specially provided. As a result, there is caused such a problem that the manufacturing equipment for the analyzing apparatus is difficult to miniaturize and simplify.

On the other hand, in the case of the sensor described in Patent Document 5, since a specimen is made to directly contact a conductive thin film and an electric signal generated based on a chemical reaction caused in the specimen is detected by a diode, the small electric signal needs to be caught by the conductive thin film. For this reason, for example, when the conductive thin film is made of a metal, there is encountered such a problem that surface roughness, an oxidation state and the like exert a large influence on the detection sensitivity, and thus the maintenance and management for a surface shape and a formation process of the conductive thin film need to be very severely carried out. In addition, in the case of the sensor described in Patent Document 5, the CCD merely senses the electric signal generated from the specimen, and thus cannot output the optimal phenomenon in the form of a two-dimensional image.

In addition, the image sensor described in Patent Document 6 observes the specimen, as an object of a movement, which is directly placed on a protective film of the image sensor. Therefore, there is caused such a problem that that image sensor is unsuitable for a measurement of a specimen having a low viscosity, and a plurality kind of specimens cannot be measured at the same time. Moreover, the sensor described in Patent Document 7 is manufactured by sticking a plurality of substrates to one another. At that time, however, there is caused such a problem that it is difficult to precisely carry out the alignment for a plurality of substrates. Furthermore, the sensor described in Patent Document 7 is manufactured for the purpose of analyzing components of a specimen such as a concentration, and thus cannot output the optical phenomenon caused in the specimen in the form of the two-directional image similarly to the case of the sensor described in Patent Document 5.

WO 2009/001988, WO 93/22678, EP 1 325 776 and US 7,316,930 describe image sensors used as diagnosis devices, each including a plurality of optical sensors and a plurality of wells for analyzing a sample using light emitted by the sample or provided by a light source outside the diagnosis device and transmitting through the sample. The wells may have a circular shape or a rectangular or quadrangular shape in terms of planar view. Manufacturing methods comprise forming a photoelectric conversion portion including a light receiving element and forming a well region defined by a wall structure, whererin the well region is positioned to correspond to the light receiving element of the photoelectric conversion portion. The wells are formed integrally on the photoelectric conversion portion by etching a substrate or film made of glass, silicon or silicon oxide.

FR 2 908 888 describes a similar device, wherein the wells are provided by a metal film in which holes are bored and which is deposited on the photoelectric conversion portion.

WO 99/49974 describes a microtiter plate in which a plurality of wells are formed by injection molding a plastic. The wells may have a hexagonal shape in terms of planar view.

WO 98/09336 describes an image sensor comprising wedge-shaped optical reflectors, wherein the reflectors may form a two-dimensional well, i.e. the wedge-shaped reflectors form a wall structure surrounding a well. The reflectors may be silicon tips comprising a metal coating and may be formed with a process including forming a mold and using the mold for forming the reflectors by replication such as stamping or injection molding. The process for forming the mold includes an electroforming step.

The present application has been made in order to solve the problems described above, and it is therefore desirable to provide an image sensor with which manufacturing equipment for the image sensor can be miniaturized and simplified, and thus which can be manufactured at a low cost and a method of manufacturing the same, and a sensor device having the same mounted thereto.

The above objects are solved by the claimed matter according to the independent claim. Various respective aspects and features of the invention are defined in the appended claims.

In order to attain the desire described above, according to an example which is useful for understanding the invention, there is provided an image sensor including: a photoelectric conversion portion including a plurality of light receiving elements for converting an incident light into an electric signal; an insulating layer made of a light transmissive material and formed so as to cover said photoelectric conversion portion; and one or multiple wells formed above the insulating layer overlying said photoelectric conversion portion. An optical phenomenon caused in a specimen filled within the one or multiple wells is detected by the plurality of light receiving elements of the photoelectric conversion portion.

In an example which is useful for understanding the invention, an image sensor is provided. The image sensor including a photoelectric conversion portion including a light receiving element; and a well region defined by a wall structure that is formed integrally on the photoelectric conversion portion, wherein the well region is positioned to correspond to the light receiving element of the photoelectric conversion portion.

In an example which is useful for understanding the invention, the well region is configured as any one of a quadrangular shape and a hexagonal shape.

In an example which is useful for understanding the invention, the wall structure includes a material selected from the group consisting of Au, Ag, Cu, Ni, Cr, Pt, Pd, Zn, Cd, and an alloy thereof.

In an example which is useful for understanding the invention, a side surface of the well region includes a side surface material that does not transmit light.

In an example which is useful for understanding the invention, the well region is configured to receive a biological specimen.

In an example which is useful for understanding the invention, the light receiving element is configured to detect the light from the biological specimen.

In an example which is useful for understanding the invention, the well region is covered with a protective film configured to protect the well region from reaction with the biological specimen.

In an example which is useful for understanding the invention, the photoelectric conversion portion is a charge coupled device or a complementary metal oxide semiconductor.

In an example which is useful for understanding the invention, an insulating layer is formed between the photoelectric conversion portion and the well region.

In an example which is useful for understanding the invention, a light reflective layer is formed on the wall structure.

In an example which is useful for understanding the invention, a light absorptive layer is formed on the wall structure.

In an example which is useful for understanding the invention, the well region and the light receiving element are substantially same in size.

In an example which is useful for understanding the invention, the well region is configured to be positioned over the light receiving element.

In an example which is useful for understanding the invention, an image sensor device is provided. The image sensor device including an image sensor including a photoelectric conversion portion and a well region, wherein the photoelectric conversion portion includes a light receiving element, wherein the well region is defined by a wall structure that is formed integrally on the photoelectric conversion portion, and wherein the well region is positioned to correspond to the light receiving element of the photoelectric conversion portion.

In an embodiment, a method of manufacturing an image sensor according to claim 1 is provided.

Further embodiments are defined in the dependent claims 2-11.

According to the present application, since the photoelectric conversion portion(s) and the one or multiple wells are formed integrally with each other, the manufacturing equipment for the image sensor or the sensor device can be miniaturized and simplified, and also the image sensor or the sensor device can be manufactured at the low cost.

Additional features and advantages are described herein, and will be apparent from the following Detailed Description and the figures.

### BRIEF DESCRIPTION OF THE FIGURES

FIG. 1 is a cross sectional view schematically showing a structure of an image sensor according to an example which is useful for understanding the invention;

FIGS. 2A to 2C are respectively views showing a method of manufacturing the image sensor according to an example which is useful for understanding the invention in the order of processes;

FIGS. 3A to 3F are respectively cross sectional views showing a method of forming a well by utilizing an electroforming method in the order of processes;

FIGS. 4A to 4G are respectively cross sectional views showing a method of forming a well in an image sensor according to a change of an example which is useful for understanding the invention by using a wall structure including a hard mask layer in the order of processes; and

FIGS. 5A to 5C are respectively cross sectional views showing a method of forming a sensor device according to an example which is useful for understanding the invention in the order of processes.

### DETAILED DESCRIPTION

Embodiments of the present application will be described in detail hereinafter with reference to the drawings.

1. First Example (structure of image sensor)

2. Second Example (manufacturing method: method of forming wells by utilizing electroforming method)

3. Change of Second Example (manufacturing method: method of forming wells by using wall structure including hard mask layer)

4. Third Example (sensor device)

1. First Example

Structure of Image Sensor

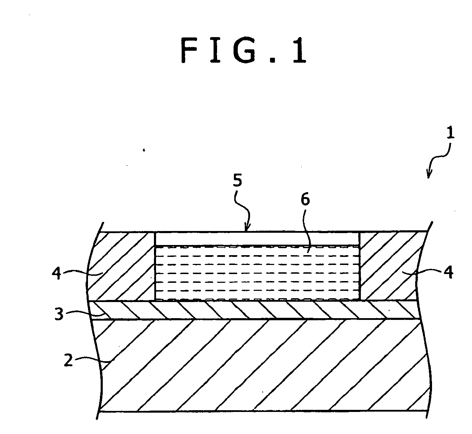

Firstly, an image sensor according to an example which is useful for understanding the invention will be described with reference to FIG. 1. FIG. 1 is a cross sectional view schematically showing a structure of an image sensor according to an example which is useful for understanding the invention. As shown in FIG. 1, in the image sensor 1 of the first example, one or multiple wells 5 in which either a gel-like or liquid specimen 6 as an object of a measurement is accumulated are formed on a photoelectric conversion portion 2 through an insulating layer 3.

Photoelectric Conversion Portion 2

The photoelectric conversion portion 2 detects an optical phenomenon caused in the specimen 6 and outputs the optical phenomenon thus detected in the form of an electric signal. A plurality of light receiving elements are disposed in a matrix in the photoelectric conversion portion 2. Such a photoelectric conversion portion 2 can be composed of a solid-state image pickup element such as a Charge Coupled Device (CCD) or a Complementary Metal Oxide Semiconductor (CMOS).

Insulating Layer 3

The insulating layer 3 electrically insulates the photoelectric conversion portion 2 and a wall structure 4 composing the well 5 from each other, and is made of a material which exerts no influence on the light detection in the specimen 6 and each of the light receiving elements. Specifically, the insulating layer 3 can be made of an inorganic material such as a silicon oxide (SiO₂) or a silicon nitride (SiNₓ), having high permeability, or a polymer material, such as polyimide, having a high melting point and high permeability.

Well 5

The well 5 is a space zoned by the wall structure 4, and, for example, is provided every one or multiple pixels of the light receiving element provided in the photoelectric conversion portion 2. Also, an optical phenomenon caused in either the gel-like or liquid specimen 6 as an object of a measurement is measured within the well 5. A height, a width and a strength of the wall structure 4 composing the well 5 are especially by no means limited, and thus all it takes is that a predetermined amount of specimen 6 can be accumulated with the height, the width and the strength of the wall structure 4 composing the wall 5.

In addition, the well 5, for example, can have either a quadrangular shape or a hexagonal shape in terms of planar view. When the well 5 has the quadrangular shape in terms of planar view, the detection precision is enhanced because the well 5 can have the shape size which is either the same as that of the light receiving element of the photoelectric conversion portion 2 or the integral multiples of the shape size of the light receiving element of the photoelectric conversion portion 2. In particular, when the well 5 has the hexagonal shape in terms of planar view, since a light emitted within the well 5 becomes easy to multiply reflect, the light receiving element can take in a light emission phenomenon caused within the well 5 at a maximum. In addition, in the case where the specimen 6 contains therein beads, when the well 5 has the hexagonal shape in terms of planar view, the detection precision is enhanced because the beads become easy to undergo the close packing.

In addition, preferably, the wall structure 4 is made of a metallic material or a part of the wall structure 4 has a metallic layer. It is noted that when the part of the wall structure 4 has the metallic layer, a material composing other parts has to have such heat resistance as to withstand a mounting process. The wall structure 4 is made of such a material, whereby the light condensing effect for the light receiving element and the light receiving efficiency of the light receiving element can be enhanced.

In addition, preferably, at least a side surface of the well 5 (the wall structure 4) is made of a material not transmitting a light. As a result, the noises can be reduced, and thus the optical phenomenon caused in the specimen 6 can be detected with a high resolution. In addition, in the image sensor 1 of the first example, a protective film may be formed on a surface of the wall structure 4. As a result, for example, it is possible to prevent an interaction between the specimen 6 and the well 5 (the wall structure 4), and a change of properties, and deterioration of the wall structure 4.

As described above, since in the image sensor 1 of the first example, the photoelectric conversion element 2 and the well 5 are formed integrally with each other, the alignment work and section become unnecessary. In addition, since the well 5 can be formed in the wafer process similarly to the case of the photoelectric conversion element 2, the alignment precision can be suppressed within several micron meters. As a result, the analysis can be carried out with the high resolution.

Moreover, since in the image sensor 1 of the first example, the pixels of the light receiving element, and wells 5 can also be formed so as to correspond to each other, the analysis can be realized with the high resolution. Furthermore, since culture or the like of a cell can be carried out within the well 5, a temporal change of the properties of the specimen 5 can also be observed.

2. Second Example

Outline of Method of Manufacturing Image Sensor

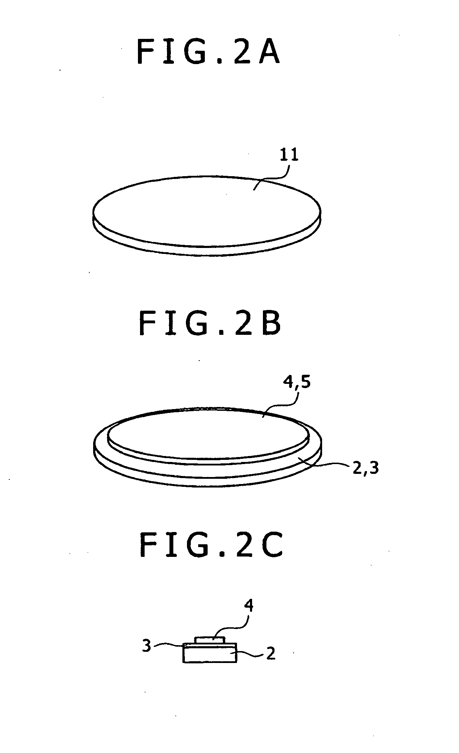

Next, a method of manufacturing the image sensor of the first example described above will be described as a second example with reference to FIGS. 2A to 2C. FIGS. 2A to 2C are respectively views showing a method of manufacturing the image sensor according to a second example in the order of processes. In the second example, firstly, as shown in FIG. 2A, the solid-state image pickup element such as the CCD or the CMOS is formed as the photoelectric conversion element 2 on a semiconductor wafer 11, and the insulating layer 3 is formed on the photoelectric conversion element 2. The methods of manufacturing the photoelectric conversion element 2 and the insulating layer 3 are by no means limited, and thus known methods can be applied thereto, respectively.

Next, as shown in FIG. 2B, the well 5 is formed on the insulating layer 3. Although a method of forming the well 5 is especially by no means limited, for example, when the wall structure 4 is made of a metallic material, an electroforming method or the like which will be described later can be applied to the method of forming the well 5. After that, as shown in FIG. 2C, the semiconductor wafer 11 is cut into the image sensor 1 by utilizing the known method.

Formation of Well 5 by Utilizing Electroforming Method

Next, a method of forming the well 5 at the wafer level by utilizing the electroforming method (metal plating method) will be concretely described by exemplifying the case where the photoelectric conversion element 2 is an existing CMOS. By utilizing the electroforming method, it is possible to form a thick metallic film, having a thickness of several micron meters to several tens of micron meters, for which it takes time to deposit a film by utilizing either a Chemical Vapor Deposition (CVD) method or a Physical Vapor Deposition (PVD) method, and thus which is difficult to form by utilizing either the CVD method or the PVD method. From this reason, the electroforming method is generally used for formation of bumps of a semiconductor device, formation of a structure of a Micro Electro Mechanical Systems (MEMS) device, or the like.

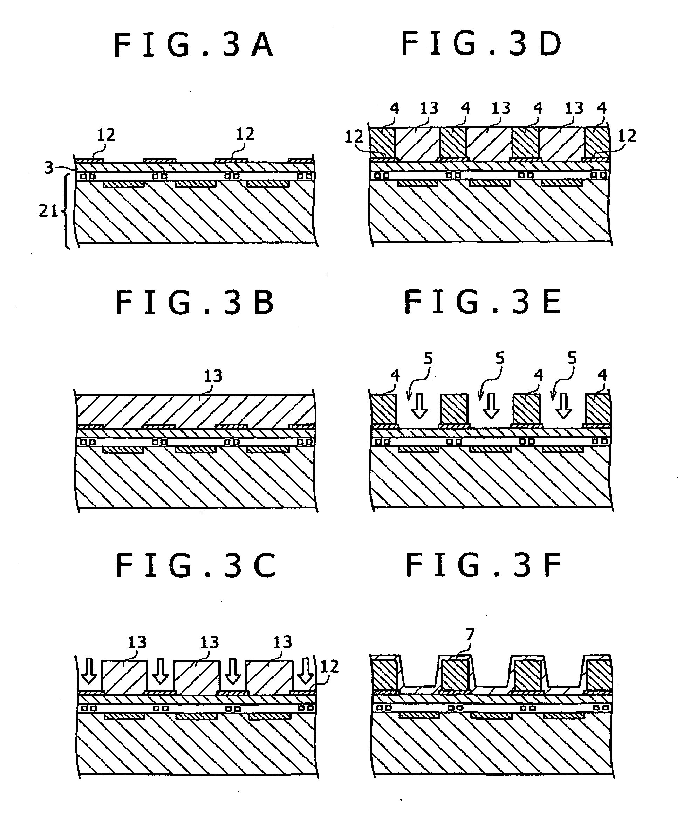

FIGS. 3A to 3F are respectively cross sectional views showing a method of forming a well 5 by utilizing the electroforming method in the order of processes. In the case where the well 5 is formed by utilizing the electroforming method, firstly, as shown in FIG. 3A, a metallic film becoming a seed layer 12 is formed in predetermined positions of a semiconductor wafer in which a plurality of CMOSs 21 are formed, and the insulating layer 3 is formed on a surface on a plurality of CMOSs 21 by utilizing a thin film depositing method such as a sputtering method or a vacuum evaporation method. It is enough for the seed layer 12 to have a thickness of several tens of nanometers. For example, the seed layer 12 can be made of Au, Ag, Cu, Ni, Cr, Pt, Pd or an alloy thereof, or a lamination film thereof.

Next, as shown in FIG. 3B, a resist liquid solution is applied to the surface of the semiconductor wafer after completion of the formation of the seed layer 12 by utilizing a spin coat method or the like, or a film resist is stuck thereto, thereby forming a thick resist layer 13. After that, as shown in FIG. 3C, the exposure and the development are carried out, thereby removing the thick resist layer 13 with portions of the thick resist layer 13 becoming the wells 5, respectively, being left.

Also, as shown in FIG. 3D, a metallic film is grown from the seed layer 12 by utilizing the electroforming method (metal plating method), thereby forming the well structure 4. At that time, for example, Au, Ag, Cu, Ni, Cr, Pt, Pd or an alloy thereof, or an alloy of Au, Ag, Cu, Ni, Cr, Pt, or Pd, and Zn, Cd or Pd having corrosion resistance can be used as the material of the wall structure 4. In addition, although a height of the wall structure 4 can be suitably set so as to correspond to the specimen 6 accumulated within the well 5, preferably, it is set as being equal to or larger than 1 µm.

Next, as shown in FIG. 3E, the thick resist layer 13 is removed by using either a peeling solution or dry ashing such as O₂, thereby forming the well 5. Also, when, for example, the specimen 6 is feared to react with the metallic material, as shown in FIG. 3F, the wall structure 4 and the well 5 may be covered with a protective film 7 so as to correspond to the characteristics of the specimen 6. The protective film includes an inorganic material, such as a silicon oxide (SiO₂) or a silicon nitride (SiNₓ), having high permeability, or a polymer material, such as polyimide, having a high melting point and high permeability. It is noted that the protective film 7 has to be formed only when necessary. In addition, when the wall structure 4 is formed by utilizing a nonelectrolytic plating method, the seed layer 12 is also unnecessary.

As has been described, with the method of manufacturing the image sensor according to the embodiment, the wall structure 4 made of the metallic material is formed by utilizing the electroforming method. Therefore, the multiple reflection is easy to cause within the well 5, and thus the image sensor which is excellent in the light condensing efficiency and the light receiving efficiency can be manufactured at the low cost. In addition, when the electroforming method is utilized, since the removal of the thick resist layer 13 after completion of the formation of the wall structure 4 is easily carried out, it is not feared that the light transmittance is reduced in a bottom portion (light receiving portion) of the well 5 due to the residual material. In addition, since in the image sensor 1, the photoelectric conversion portion and the well are formed integrally with each other, the alignment section becomes unnecessary, and thus manufacturing equipment for the image sensor 1 can be miniaturized and simplified.

3. Change of Second Example

Outline of Method of Manufacturing Image Sensor

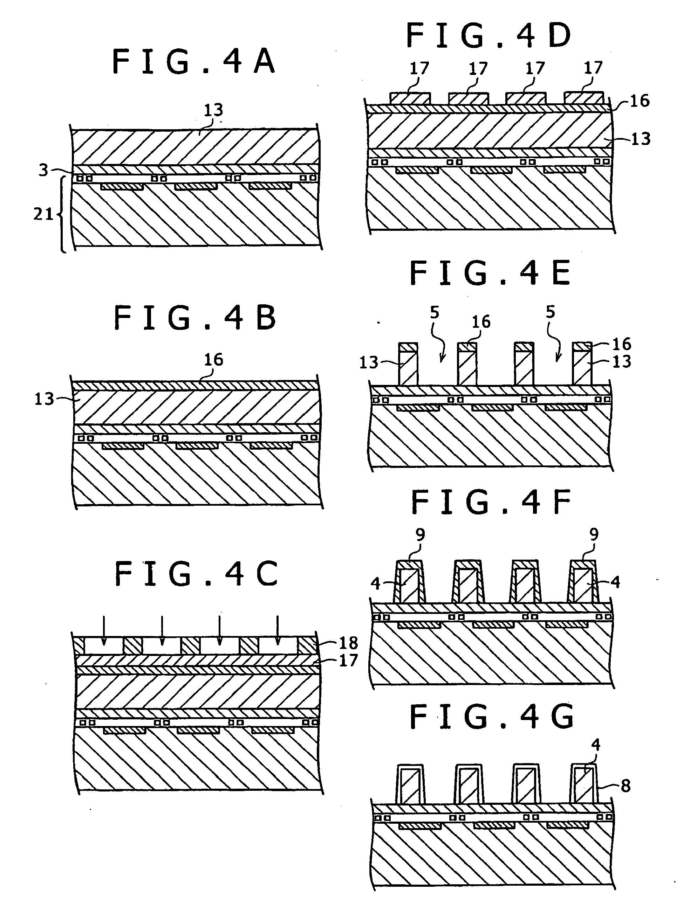

Next, a method of forming the well 5 by using the wall structure including a hard mask layer will be described as a change of the second example with reference to FIGS. 4A to 4G. Although with the method of manufacturing the image sensor 1 according to the embodiment described above, the wall structure 4 made of the metallic material is formed by utilizing the electroforming method. According to an example, the wall structure 4 can also be formed by combining a hard mask layer made of a metallic material and a resist layer with each other.

Method of Forming Well

FIGS. 4A to 4G are respectively cross sectional views showing a method of forming the well 5 by using the wall structure including a hard mask layer in the order of processes. In the change of the second example, firstly, as shown in FIG. 4A, the resist liquid solution is applied to the surface of the semiconductor wafer in which a plurality of CMOSs 21 are formed, and the insulating layer 3 is formed on the surface on a plurality of CMOSs 21 by utilizing the spin coat method or the like, or the film resist is stuck thereto, thereby forming the thick resist layer 13. Preferably, a material, such as a polyimide resin or PEEK, having the heat resistance of 200°C or more is used as the resist material used at that time.

Next, as shown in FIG. 4B, a hard mask 16 made of a metallic material or the like is formed on the thick resist layer 13. After that, as shown in FIG. 4C, a resist layer 17 is formed on the hard mask layer 16, and patterning for formation of the well 5 is carried out by using a mask 18. Also, as shown in FIG. 4D, the exposure and the development are carried out, thereby removing a portion of the resist layer 17 becoming the wall structure 4. In addition, as shown in FIG. 4E, the metal etching, and the etching and ashing of the thick resist layer 13 are carried out, thereby forming the well 5.

When a part of the well structure 4 is composed of the resist layer 13 in such a manner, the light emitted from the specimen is made incident to a side surface of the well 5 (the wall structure 4) to be accidentally detected in the well 5 adjacent to that well by a detecting portion in some cases. For the purpose of preventing such mal-detection to enhance the detection precision, either a reflective layer for reflecting the detection light or an absorptive layer for absorbing the detection light has to be provided on the side surface of the well 5 (the wall structure 4).

When the reflective layer 9 is provided on the wall structure 4, for example, as shown in FIG. 4F, the reflective layer 9 includes a metallic layer made of Au, Ag, Pt, Al or the like has to be formed on the surface of the wall structure 4. In addition, when the absorptive layer is provided on the wall structure 4, for example, as shown in FIG. 4G, after a black resin liquid solution obtained by mixing a resist liquid solution with carbon or the like has to be applied to the surface of the wall structure 4, and the exposure has to be then carried out, post exposure bake and development have to be carried out, thereby forming a black resist layer 8 as an example of the absorptive layer.

With the method of manufacturing the image sensor according to the second example, since the hard mask layer is provided in a part of the wall structure 4, the removal of the thick resist layer 13 after completion of the formation of the wall structure 4 is easily carried out, and thus the image sensor which is excellent in the detection sensitivity and the detection precision can be manufactured at the low cost. It is noted that the constitutions and effects other than those described above in the method of manufacturing the image sensor of the change of the second example are the same as those in the second example described above.

4. Third Example

Structure of Sensor Device

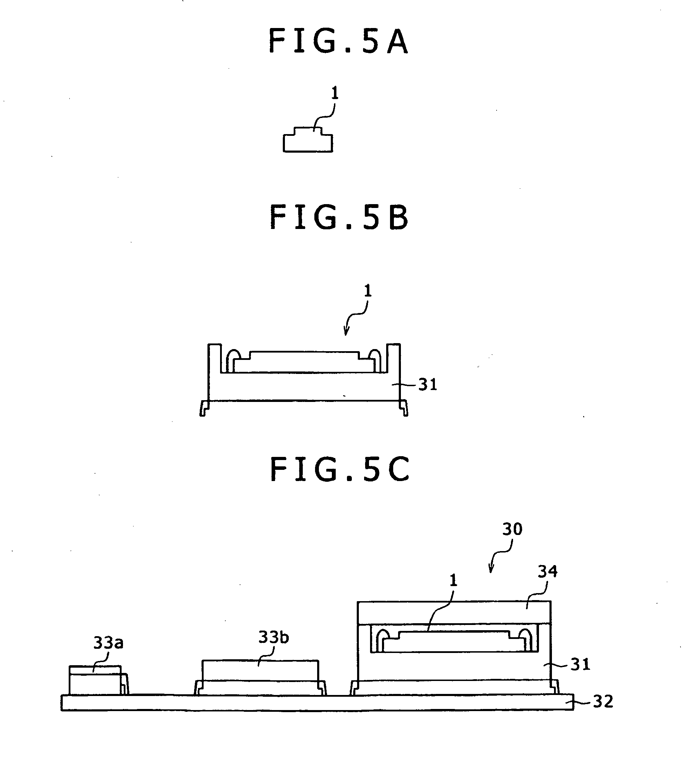

Next, a sensor device according to a third example will be described with reference to FIGS. 5A to 5C. FIGS. 5A to 5C are respectively cross sectional views showing a method of forming a sensor device according to a third example in the order of processes. As shown in FIG. 5C, the sensor device 30 of the third example is such that a package substrate 31 to which the image sensor 1 of the first example described above is mounted is mounted together with other electronic parts or components 33a and 33b onto a circuit board 32.

In the sensor device 30, after the specimen 6 has been filled in the well 5 provided within the image sensor 1, a cap 34 can be placed on the package substrate 31, and the inside of the package can also be encapsulated with an adhesive agent, a light curing agent, thermal compression bond or the like. In this case, a material of the cap 34 is especially by no means limited, and thus can be suitable selected and used.

Method of Manufacturing Sensor Device 30

Next, a method of manufacturing the sensor device 30 described above will be described with reference to FIGS. 5A to 5C. For manufacturing the sensor device 30 of the third example, firstly, the image sensor 1 shown in FIG. 5A is mounted to the package substrate 31 (refer to FIG. 5B). Next, as shown in FIG. 5C, the package substrate 31 to which the image sensor 1 is mounted is mounted together with the electronic parts or components 33a and 33b such as a processing card (FPGA: Field Programmable Gate Array) for processing detected data from the image sensor 1 in real time to the circuit board 32 including a peripheral circuit such as a drive circuit.

Operation

With the sensor device 30 of the third example, when the specimen 6 has been filled in the well 5 provided within the image sensor 1, the optical phenomenon caused in the specimen 6 is detected by the photoelectric conversion portion 2, and is then outputted in the form of a two-dimensional image. At that time, in the case or the like where the sensor device 30 of the third example, for example, is used as the chemical sensor, a light may be radiated from a light source installed in the outside to the specimen 6 filled in the well 5. In addition, in the case where the sensor device 30 of the third example, for example, is used for inspecting a gene, light emission from the specimen 6 itself can also be detected.

Since the image sensor 1 in which the photoelectric conversion portion 2 and the well 5 are formed integrally with each other is mounted to the sensor device 30 of the third example, the alignment section is unnecessary. As a result, the manufacturing equipment for the sensor device 30 can be miniaturized and simplified, and the analysis having the high resolution can be realized at the low cost. In addition, when the image sensor 1 is used in which the wall structure 4 is made of the metallic material, due to the multiple reflection effect within the well 5, the detection efficiency can be largely enhanced as compared with the case of the existing sensor device.

It should be understood that various changes and modifications to the presently preferred embodiment described herein will be apparent to those skilled in the art. Such changes and modifications can be made without departing from the scope and without diminishing its intended advantages. It is therefore intended that such changes and modifications be covered by the appended claims.

## Claims

1. A method of manufacturing an image sensor (1), comprising:
forming a photoelectric conversion portion (2) including a light receiving element; and
forming a well region (5) defined by a wall structure (4) that is formed integrally on the photoelectric conversion portion (2), wherein the well region (5) is positioned to correspond to the light receiving element of the photoelectric conversion portion (2),
**characterized in that**
the wall structure (4) includes a metal material selected from the group consisting of Au, Ag, Cu, Ni, Cr, Pt, Pd, Zn, Cd, and an alloy thereof, wherein the metal material of the wall structure (4) is formed by
forming a seed layer (12) made of a metallic film on the photoelectric conversion portion (2) at the position of the wall structure (4),
forming a resist layer (13) on the photoelectric conversion portion (2) and on the seed layer (12),
patterning the resist layer (13) such that the resist layer (13) is left only at the position of the well region (5), and
electroforming of the metal material of the wall structure (4) from the seed layer (12); and
the resist layer (13) is removed after electroforming the metal material of the wall structure (4).

2. The method of claim 1, wherein the well region (5) is configured as any one of a quadrangular shape and a hexagonal shape in terms of planar view.

3. The method of claim 1 or 2, wherein the light receiving element is configured to detect light from a biological specimen (6) configured to be provided in the well region (5) or to detect light radiated from a light source installed in the outside of the image sensor (1) to a biological specimen (6) configured to be provided in the well region (5).

4. The method of any one of the preceding claims, further comprising forming a protective film (7) covering the well region (5) and configured to protect the well region (5) from reaction with a biological specimen (6) configured to be provided in the well region (5).

5. The method of any one of the preceding claims, wherein the photoelectric conversion portion (2) is a charge coupled device or a complementary metal oxide semiconductor.

6. The method of any one of the preceding claims, further comprising forming an insulating layer (3) between the photoelectric conversion portion (2) and the well region (5).

7. The method of any one of the preceding claims, further comprising forming a light reflective layer (9) on the wall structure (4).

8. The method of any one of the preceding claims, further comprising forming a light absorptive layer (8) on the wall structure (4).

9. The method of any one of the preceding claims, wherein the well region (5) and the light receiving element are substantially same in size.

10. The method of any one of the preceding claims, wherein the well region (5) is configured to be positioned over the light receiving element.

11. A method of manufacturing an image sensor device (30) including an image sensor (1), comprising the method of manufacturing an image sensor (1) according to any one of the preceding claims.

## Patentansprüche

1. Verfahren zur Herstellung eines Bildsensors (1), das Folgendes aufweist:
Bilden eines photoelektrischen Umwandlungsabschnitts (2), der ein Lichtempfangselement aufweist; und
Bilden eines Potentialmuldenbereichs (5), der durch eine Wandstruktur (4) abgegrenzt wird, die einteilig auf dem photoelektrischen Umwandlungsabschnitt (2) gebildet wird, wobei der Potentialmuldenbereich (5) positioniert wird, um dem Lichtempfangselement des photoelektrischen Umwandlungsabschnitts (2) zu entsprechen,
**dadurch gekennzeichnet, dass**
die Wandstruktur (4) ein Metallmaterial aufweist, das von der Gruppe ausgewählt wird, die aus Au, Ag, Cu, Ni, Cr, Pt, Pd, Zn, Cd und einer Legierung davon ausgewählt wird, wobei das Metallmaterial der Wandstruktur (4) durch Folgendes gebildet wird:
Bilden einer Keimschicht (12), die aus einer Metallschicht auf dem photoelektrischen Umwandlungsabschnitt (2) an der Position der Wandstruktur (4) hergestellt wird,
Bilden einer Resistschicht (13) auf dem photoelektrischen Umwandlungsabschnitt (2) und auf der Keimschicht (12),
Mustern der Resistschicht (13), derart, dass die Resistschicht (13) lediglich an der Position des Potentialmuldenbereichs (5) gelassen wird, und
Galvanoformen des Metallmaterials der Wandstruktur (4) von der Keimschicht (12); und
wobei die Resistschicht (13) nach dem Galvanoformen des Metallmaterials der Wandstruktur (4) entfernt wird.

2. Verfahren nach Anspruch 1, wobei der Potentialmuldenbereich (5) in einer ebenen Ansicht als eine von einer viereckigen und einer sechseckigen Form ausgestaltet wird.

3. Verfahren nach Anspruch 1 oder 2, wobei das Lichtempfangselement ausgestaltet wird, um Licht von einem biologischen Probekörper (6) zu ermitteln, der ausgestaltet ist, um in dem Potentialmuldenbereich (5) bereitgestellt zu werden, oder Licht zu ermitteln, das von einer Lichtquelle, die in der Außenseite des Bildsensors (1) eingerichtet ist, zu einem biologischen Probekörper (6) ausgestrahlt wird, der ausgestaltet ist, um in dem Potentialmuldenbereich (5) bereitgestellt zu werden.

4. Verfahren nach einem der vorhergehenden Ansprüche, das ferner das Bilden einer Schutzschicht (7) aufweist, die den Potentialmuldenbereich (5) bedeckt und ausgestaltet wird, um den Potentialmuldenbereich (5) vor einer Reaktion mit einem biologischen Probekörper (6) zu schützen, der ausgestaltet ist, um in dem Potentialmuldenbereich (5) bereitgestellt zu werden.

5. Verfahren nach einem der vorhergehenden Ansprüche, wobei der photoelektrische Umwandlungsabschnitt (2) ein ladungsgekoppeltes Bauelement oder ein CMOS-Halbleiter (CMOS = Complementary Metal Oxide) ist.

6. Verfahren nach einem der vorhergehenden Ansprüche, das ferner das Bilden einer Isolationsschicht (3) zwischen dem photoelektrischen Umwandlungsabschnitt (2) und dem Potentialmuldenbereich (5) aufweist.

7. Verfahren nach einem der vorhergehenden Ansprüche, das ferner das Bilden einer lichtreflektierenden Schicht (9) auf der Wandstruktur (4) aufweist.

8. Verfahren nach einem der vorhergehenden Ansprüche, das ferner das Bilden einer lichtabsorbierenden Schicht (8) auf der Wandstruktur (4) aufweist.

9. Verfahren nach einem der vorhergehenden Ansprüche, wobei der Potentialmuldenbereich (5) und das Lichtempfangselement im Wesentlichen dieselbe Größe aufweisen.

10. Verfahren nach einem der vorhergehenden Ansprüche, wobei der Potentialmuldenbereich (5) ausgestaltet wird, um über dem Lichtempfangselement positioniert zu werden.

11. Verfahren zur Herstellung einer Bildsensorvorrichtung (30), die einen Bildsensor (1) aufweist, das das Verfahren zur Herstellung eines Bildsensors (1) nach einem der vorhergehenden Ansprüche aufweist.

## Revendications

1. Procédé de fabrication d'un capteur d'image (1), comprenant :
la formation d'une partie de conversion photoélectrique (2) comportant un élément récepteur de lumière ; et
la formation d'une région de puits (5) définie par une structure de paroi (4) qui est formée d'un seul tenant sur la partie de conversion photoélectrique (2), la région de puits (5) étant positionnée pour correspondre à l'élément récepteur de lumière de la partie de conversion photoélectrique (2),
**caractérisé en ce que**
la structure de paroi (4) comporte un matériau métallique choisi dans le groupe constitué par Au, Ag, Cu, Ni, Cr, Pt, Pd, Zn, Cd et un alliage de ceux-ci, le matériau métallique de la structure de paroi (4) étant formé
en formant une couche de germe (12) constituée d'un film métallique sur la partie de conversion photoélectrique (2) à la position de la structure de paroi (4),
en formant une couche de réserve (13) sur la partie de conversion photoélectrique (2) et sur la couche de germe (12),
en modelant la couche de réserve (13) de telle sorte que la couche de réserve (13) ne soit laissée qu'à la position de la région de puits (5), et
en électroformant le matériau métallique de la structure de paroi (4) à partir de la couche de germe (12) ; et
la couche de réserve (13) est retirée après électroformage du matériau métallique de la structure de paroi (4).

2. Procédé selon la revendication 1, dans lequel la région de puits (5) est configurée comme une forme quadrangulaire ou une forme hexagonale en vue en plan.

3. Procédé selon la revendication 1 ou 2, dans lequel l'élément récepteur de lumière est configuré pour détecter la lumière provenant d'un échantillon biologique (6) configuré pour être disposé dans la région de puits (5) ou pour détecter la lumière rayonnée depuis une source de lumière installée à l'extérieur du capteur d'image (1) jusqu'à un échantillon biologique (6) configuré pour être disposé dans la région de puits (5).

4. Procédé selon l'une quelconque des revendications précédentes, comprenant en outre la formation d'un film protecteur (7) recouvrant la région de puits (5) et configuré pour protéger la région de puits (5) contre une réaction avec un échantillon biologique (6) configuré pour être disposé dans la région de puits (5).

5. Procédé selon l'une quelconque des revendications précédentes, dans lequel la partie de conversion photoélectrique (2) est un dispositif à couplage de charge ou un semi-conducteur à oxyde métallique complémentaire.

6. Procédé selon l'une quelconque des revendications précédentes, comprenant en outre la formation d'une couche isolante (3) entre la partie de conversion photoélectrique (2) et la région de puits (5).

7. Procédé selon l'une quelconque des revendications précédentes, comprenant en outre la formation d'une couche réfléchissant la lumière (9) sur la structure de paroi (4).

8. Procédé selon l'une quelconque des revendications précédentes, comprenant en outre la formation d'une couche absorbant la lumière (8) sur la structure de paroi (4).

9. Procédé selon l'une quelconque des revendications précédentes, dans lequel la région de puits (5) et l'élément récepteur de lumière sont sensiblement identiques en taille.

10. Procédé selon l'une quelconque des revendications précédentes, dans lequel la région de puits (5) est configurée pour être positionnée par-dessus l'élément récepteur de lumière.

11. Procédé de fabrication d'un dispositif à capteur d'image (30) comportant un capteur d'image (1), comprenant le procédé de fabrication d'un capteur d'image (1) selon l'une quelconque des revendications précédentes.
